# EUROPÄISCHE PATENTANMELDUNG

(11) **EP 2 631 954 A1**
(43) Veröffentlichungstag der Anmeldung: **28.08.2013**
(21) Anmeldenummer: 12156345.6
(22) Anmeldetag: 21.02.2012
(51) Int. Cl.: H01L 31/0336, H01L 31/072, H01L 31/0725

(54) **Kupferoxid (Cu2O, Cu4O3 oder CuO)-Heteroübergänge, insbesondere für Solarzellen und Tandemzellen**

(71) Anmelder: Justus-Liebig-Universität Gießen, 35390 Giessen (DE)
(72) Erfinder: Meyer, Bruno, 35440 Großen-Linden (DE); Becker, Martin, 35625 Hüttenberg (DE); Hering, Karl Philipp, 35510 Butzbach (DE); Kramm, Benedikt, 65594 Runkel (DE); Polity, Angelika, 61231 Bad Nauheim (DE); Reppin, Daniel, 35753 Greifenstein-Allendorf (DE)
(74) Vertreter: Stumpf, Peter

(57) **Zusammenfassung**

Die vorliegende Erfindung betrifft Heteroübergänge, insbesondere zur Verwendung als pn-Diode, ihre Herstellung, sowie daraus aufgebaute photovoltaische Solarzellen. Der Heteroübergang weist ein der Kupferoxide Cu₂O, Cu₄O₃ oder CuO auf, das als Absorberschicht den p-leitenden Teil der Diode ausbildet. Der n-leitende Teil der Diode weist (Al, In)GaN bei einer Cu₂O Absorberschicht, beziehungsweise (Al, In)GaN oder ZnO-basierte Systeme (wie MgZnO, BeZnO) bei Cu₄O₃ und CuO Absorberschichten auf. Diese p- und n-leitende Teile können eine Tandemsolarzelle ausbilden. Cu₂O, Cu₄O₃ oder CuO werden mittels eines Kathodenzerstäubungsprozesses mit Nutzung eines Sauerstoffflusses im Plasma hergestellt.

## Beschreibung

Die vorliegende Erfindung betrifft neuartige Heteroübergänge, insbesondere für photovoltaische Solarzellen, sowie daraus aufgebaute Tandem oder Mehrfach-Zellen und andere elektronische oder optische Bauteile, wie etwa Transistoren, LEDs, JFETs etc. und die Herstellung.

### Stand der Technik

Cu₂O ist ein von Natur aus p-leitender Halbleiter. Cu₂O hat eine Bandlücke von 2.1 eV, damit berechnet sich mit dem Shockley-Queisser (SQL) Modell eine theoretische Effizienz für Solarzellen von 21%. Einen Absorptionskoeffizienten von 10⁵ cm⁻¹ erreicht man bei 2.5 eV, dort liegt die Effizienz bei 17%. Kupferoxide (Cu₂O, Cu₄O₃, CuO) sind auch deshalb sehr interessant als Solarabsorber-Material, da es eine nicht-toxische Verbindung darstellt, die Komponenten Cu und O nahezu unbeschränkt verfügbar sind, und die Herstellung der Oxide auch großtechnisch über z.B. Kathodenzerstäubungsverfahren bei niedrigem Energieaufwand möglich ist.

Historisch wurden zuerst Cu₂O Schottkydioden untersucht, jedoch zeigte es sich, dass alle Metallkontakte aufgrund der Oxidation an der Grenzfläche Cu₂O/Metall nur niedrige Barrierehöhen liefern. Um das Materialsystem voranzutreiben wurde versucht Cu₂O n-leitend herzustellen. Obwohl es vereinzelt Erfolgsmeldungen gibt, scheint aufgrund physikalischer Gesetzmäßigkeiten (Fermi-Level-Pinning) dieser Weg zur p-n Diode ausgeschlossen zu sein. Alternativ können Heterostrukturen d.h. p-leitendes Cu₂O als Solarabsorber und ein n-leitender transparenter Frontkontakt (durchlässig für das Licht bis ins UV) wie ZnO, Indiumzinnoxid (ITO) als Solarzellen realisiert werden. In der Literatur gibt es Berichte zu p-Cu₂O/n-ZnO Solarzellen, jedoch mit niedriger Effizienz (< 2%). In der Regel werden Grenzflächenwechselwirkungen, Depositionsbedingungen und mangelnde kristallographische Qualität als Gründe angegeben.

Es wurden nun eigene Untersuchungen zur Ursache der niedrigen Effizienz und zur Vermeidung der Nachteile im Stand der Technik, bezogen auf eine verbesserte photovoltaische Solarzelle und deren Herstellung, unternommen.

Überraschenderweise, wurde der eigentliche, d.h. ursächliche, physikalische Effekt in der Größe der Banddiskontinuitäten (BD) im Leitungsband und Valenzband zwischen Cu₂O und ZnO gefunden.

Messungen zur Bestimmung der BD zwischen ZnO und Cu₂O mittels direkten, experimentellen Methoden wie Röntgenphotoelektronenspektroskopie (XPS) gibt es in Referenzen (Ozawa). Diese sind in Übereinstimmung mit unseren Messungen, mit einem Wert der BD im Leitungsband von ca. 1 eV. Damit folgt als direkte Konsequenz, eine geringe photovoltaische Effizienz.

Die Erfindung öffnet über das ebenfalls gefundene Herstellverfahren den Weg zur Herstellung neuer Heteroübergänge unter Verwendung der genannten CuₓO_{y}-Verbindungen und deren Legierungen oder Gemische, insbesondere in Form von polykristallinen und amorphen Mischungen.

### Aufgabe der Erfindung

Die übergeordnete Aufgabe der Erfindung ist es, einen neuartigen Heteroübergang unter Verwendung von geeigneten CuₓO_{y}-Verbindungen und insbesondere eine pn-Diode vorzusehen, welche insbesondere in der Ausführung als Solarzelle günstiger ist und/oder deutlich höherer Wirkungsgrade, als vergleichbare günstige Solarzellen aufweist. Dazu ist ein geeignetes Herstellungsverfahren für die CuₓO_{y}-Verbindungen und damit den Heteroübergang und damit insbesondere einen pn-Übergang erforderlich. Diese Aufgaben werden gelöst durch den Gegenstand von Anspruch 1 bzw. von Anspruch 4.

Diese übergeordnete Aufgabe besteht im Wesentlichen aus den drei Teilaufgaben:
TA1: Vorsehung eines geeigneten Systems mit einem p-leitenden Oxid aus der Gruppe CuₓO_{y} und einem n-leitenden, für die photovoltaische Anwendung im weiten Wellenlängenbereich transparenten Teil. Geeignet, so wurde gefunden, ist ein solches System dann,
   wenn a) grenzflächenbedingt, die Interdiffusion und Reduktion des p-leitenden und Kupfer enthaltenden Oxids weitgehend vermieden wird und
   wenn b) die Leitungsbanddiskontinuität der beiden Teile signifikant verringert wird, d.h. ein Wert unter 0.4 eV, idealerweise 0 eV.
TA2: Vorsehung eines Herstellungsverfahrens für das oben genannte p-leitende Oxidsystem aus der oben genannten Gruppe und Vorsehung einer Methode darin, um die Eigenschaften für die Anwendung in photovoltaischen Solarzellen (Stabile Phasen, Absorption bei kleinen Energien und hohe Absorptionskonstanten) bei der Herstellung gezielt und reproduzierbar einzustellen.
TA3: Vorsehung eines geeigneten Schichtaufbaus, umfassend ein System, welches Aufgabe TA1 löst und/oder welches ein Teilsystem, hergestellt nach TA2 umfasst.

Die Lösungen und dabei gewonnenen Erkenntnisse zu TA1 bis TA3 werden im Folgenden näher dargestellt.

Es zeigen:
Fig 1. XPS-Spektren der reinen "bulk" Materialien (a-c) und der Heterostrukturen (insets).
Fig 2: Bandanpassung der Heterostrukturen ZnO/GaN, ZnO/Cu20 und GaN/ Cu2O.
Fig.3: Schematischer Aufbau eine Cu20/(Al,In)GaN Solarzelle
Fig.4: Absorptionseigenschaften als Funktion des Sauerstoffflusses mit dem graduellen Übergang von Cu20 über Cu403 nach CuO.
Fig.5: Löcherkonzentration als Funktion des Sauerstoffflusses mit dem graduellen Übergang von Cu20 über Cu403 nach CuO.
Fig.6: Absorptionskoeffizient für Cu20, Cu403 und CuO (aus Ellipsometrie).
Fig.7: Schematischer Aufbau einer auf Kupferoxid basierenden Tandemsolarzelle (Cu20 mit Cu403; Cu20 mit CuO oder Cu403 mit CuO).

### Ad TA1:

Erstes Ziel war es ein System zu finden, das a) die Oxid (Cu₂O)/Oxid (ZnO) Grenzfläche und damit Interdiffusion und Reduktion des Cu₂O vermeidet und b) die Leitungsbanddiskontinuität signifikant auf Werte < 0.4 eV reduziert.

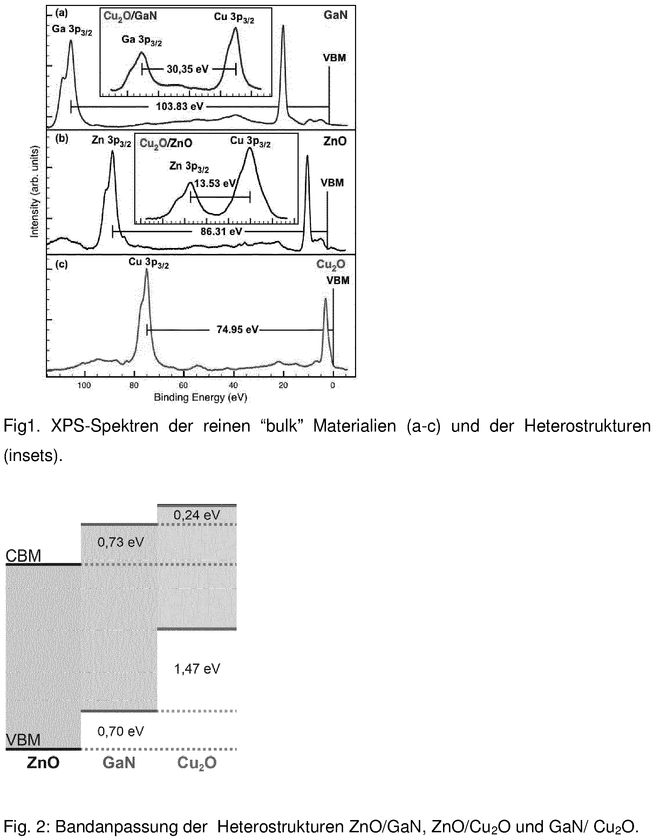

Lösung: Hier bieten sich die Oxid/Nitrid Systeme mit einer inerten Grenzfläche an, darüber hinaus müssen die NitridHalbleiter mit guter n-Dotierbarkeit sein, eine große Bandlücke für die Transparenz im Sichtbaren haben um als sog. Fensterschicht für p-Cu₂O wirken zu können. In der Tat zeigten die XPS Messungen (Fig.1) den entscheidenden Vorteil mit Galliumnitrid als Fensterschicht mit einer BD im Leitungsband von nur 0.24 eV (Fig.2) .

Solarzellenstrukturen bestehend aus Saphir (Substrat)/n-GaN/p-Cu20 wurden strukturiert, mit Metallkontakten auf n-GaN und Gold-Metallgitter auf Cu20 mit photovoltaischem Effekt.

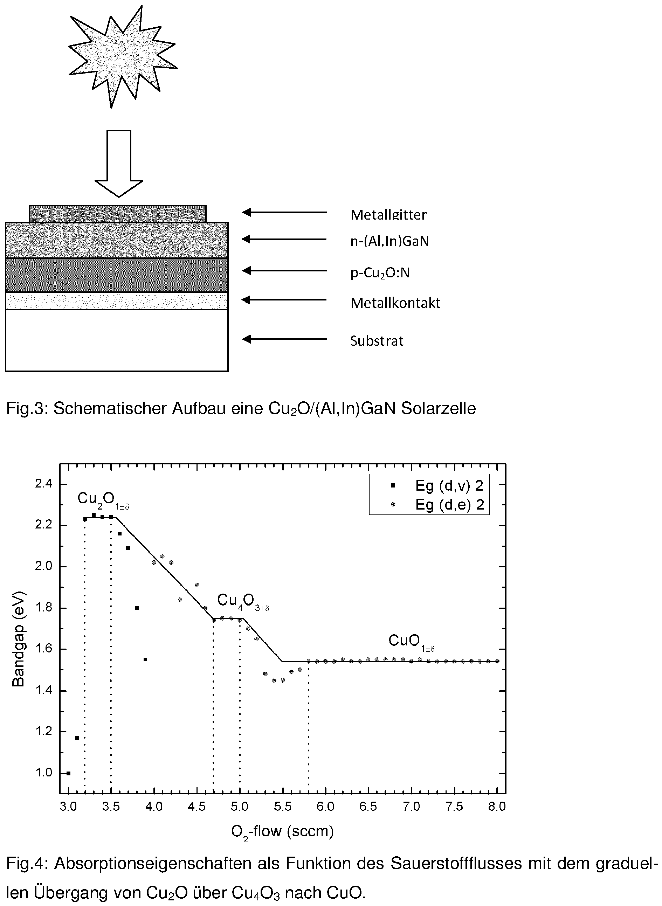

Eine photovoltaische Zelle aus Cu20/Nitrid kann schematisch auch wie in Fig. 3 dargestellt aufgebaut sein:
Substrat: Glas, Kunststoff,...
p-Cu20: undotiert oder Stickstoff-dotiert zur Einstellung der Ladungsträgerdichte
n-(Al,In)GaN: n-leitendes Nitrid der entsprechenden Zusammensetzung um den Leitungsbandsprung zu minimieren bzw. die Performance zu optimieren.

Metallisierung: entsprechendes Metall passend zu Nitridhalbleiter, strukturiert zur besseren Aufsammlung der Ladungsträger. Kontaktierung des p-Cu20 mit Gold und Haftver-Abschluß der Struktur zur Sonnenseite hin ist eine Deckschicht und Antireflexschicht wie von anderen Zelltypen (z.B CIGS/ZnO) bekannt.

Oder als Superstrate Konfiguration mit Substrat/(Al,In)GaN Fensterschicht, darauf p-Cu20 und zum Abschluß die Antireflexschicht. Metallisierung wie gehabt.

### Ad TA2:

Absorptionseigenschaften von Cu20 sind aufgrund der Bandstruktureigenschaften erst bei ca. 2.4 eV bei 5x104 cm-1 was aber den Einsatz als Dünnschichtabsorber immer noch zulässt. Ziel war es stabile Phasen zu synthetisieren außer dem bekannten CuO, die bei kleineren Energien absorbieren und hohe Absorptionskonstanten besitzen.

Die Untersuchung zur Herstellung der Oxide mittels eines metallischen Cu Targets (im Radiofrequenz Sputterprozess bei Raumtemperatur) oder eines keramischen Cu₂O Targets zeigten zum einen, einen graduellen Übergang von Cu₂O über Cu₄O₃ nach CuO als Funktion des Sauerstoffflusses im Plasma, ebenso aber auch die Variation der Trägerdichte (siehe Bilder 4 und 5) innerhalb jeder Phase. Es ist also möglich, im selben Prozess, nur über die Variation des Sauerstoffs im Plasma, die drei Modifikationen Cu20, Cu403 und CuO als isolierte Systeme zu synthetisieren. Gleichzeitig kann innerhalb einer jeden Phase die Trägerdichte von ca. 5x1015 bis 1x1019 cm-3 durch eine feine Variation des Sauerstoffflusses eingestellt werden. Damit können die optischen Absorptions- wie die elektrischen Transporteigenschaften gezielt beeinflusst und gesteuert werden. Die kristallinen Phasen (phasenrein) wurden über 4-Kreis-Röntgendiffraktometrie bestätigt.

Ebenso wurde gefunden, dass es über die Einstellung des Parameters Sauerstofffluss möglich ist, polykristalline oder amorphe Gemische, diese auch mit unterschiedlicher Konzentration dieser drei Elemente Cu₂O, Cu₄O₃ und CuO herzustellen.

### Ad TA3:

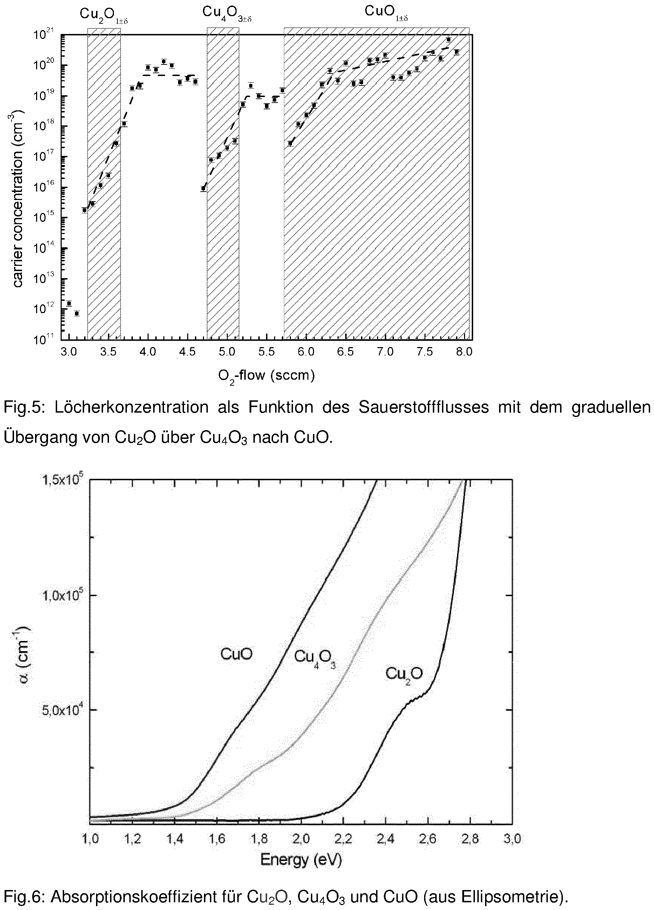

Aufgrund der erreichten guten Eigenschaften, insbesondere in der Einstellbarkeit und auch der erstmals ermittelten Absorptionskante von Cu403 sind sowohl Einfachzellen, erstmals mit Cu403, als dem p-leitenden Oxid-Teil, als auch Tandemzellen vorstellbar: Man sieht in Fig.6, dass Cu403 mit seinem Einsatz bei ca 1.4 eV sehr nahe am Maximum des SQL (1.45 eV) liegt.

Dies eröffnet die Möglichkeiten:
a) Cu403 als Absorbermaterial zu nutzen also als Einfachsolarzelle und
b) eine Tandemsolarzelle aus Cu20 und Cu4O3/CuO

zu realisieren mit den entsprechenden transparenten Frontkontakten aus den Halbleitern der Gruppe-III-Nitride (Al-In-Ga-Nitrid, binär, ternär und quaternär). Für optimale Tandemzellen (Effizienz 42 %) müssen die zwei Absorbermaterialien bei 1.0 eV und 1.9 eV den Einsatz des Absorptionskoeffizienten (elektronische Bandlücke) haben. Mit den Kupferoxidverbindungen sind Wirkungsgrade bis 35% realisierbar.

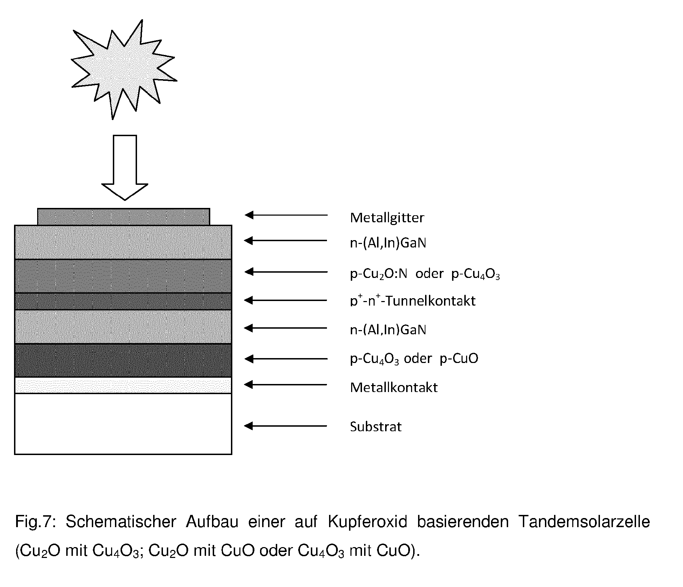

Die Struktur der Tandemzelle ist in Fig.7 dargestellt.
Substrat: Glas, Kunststoff,...
p-CuxOy: undotiert, Einstellung der Ladungsträgerdichte über Sauerstoffvariation
n-(Al,In)GaN: n-leitendes Nitrid der entsprechenden Zusammensetzung um den Leitungsbandsprung zu minimieren bzw. die Performance zu optimieren.

Erste Diode also aus n-(Al,In)GaN / p-Cu20 oder n-(Al,In)GaN / p-Cu403, die mit der folgenden zweiten über einen Tunnelkontakt verbunden wird.

p+-n+-Tunnelkontakt: p+-Schicht des entsprechenden Oxids gefolgt von der n+-Schicht aus dem entsprechenden Fenstermaterial (z.B. n+- AlGaN,...), aufgebaut als Tunnelübergang mit den notwendigen Schichtdicken.
Zweite Diode also aus entsprechend
n-(Al,In)GaN / p-Cu403 oder n-(Al,In)GaN / p-CuO

Metallisierung: entsprechendes Metall passend zu Nitridhalbleiter, strukturiert zur besseren Aufsammlung der Ladungsträger.

## Patentansprüche

1. pn-Diode, insbesondere geeignet zur Anwendung als photovoltaische Solarzelle, aufweisend ein Substrat, einen p-leitenden, einen n-leitenden Teil und Elektroden oder Kontakte zur Abführung der getrennten Ladungsträger, **dadurch gekennzeichnet, dass** der p-leitende Teil der Diode mindestens eines der Elemente der folgenden Gruppe, bestehend aus Cu₂O, Cu₄O₃, CuO als Absorberschicht aufweist.

2. pn-Diode nach Anspruch 1, **dadurch gekennzeichnet, dass** der n-leitende Teil (Al,In)GaN bei einer Cu₂O Absorberschicht, beziehungsweise (Al,In)GaN oder ZnObasierte Systeme, wie etwa MgZnO, BeZnO, bei Cu₄O₃ und CuO Absorberschichten aufweist.

3. Tandemsolarzelle umfassend n-leitende Teile gemäß Anspruch 2, **dadurch gekennzeichnet, dass** die p-leitenden Teile jeweils ein Element der Gruppe Cu₂O, Cu₄O₃, CuO als Absorberschicht aufweist.

4. Heteroübergang in einem elektronischen oder/und optischen Bauteil, wie pn-Diode, Transistor, LED oder JFET, **dadurch gekennzeichnet, dass** der Heteroübergang eines der Elemente der folgenden Gruppe, bestehend aus Cu₂O, Cu₄O₃ in amorpher, kristalliner oder polykristalliner Form oder Mischungen der Elmente in reiner oder gemischter Weise der oben genannten Form aufweist.

5. Herstellung eines Bauteils gemäß Anspruch 1, 2, 3 oder 4, **dadurch gekennzeichnet, dass** für die Herstellung der Elemente der Gruppe Cu₂O, Cu₄O₃, CuO, mindestens in Bezug auf die Einstellung der Absorptionseigenschaften und/oder der Löcherkonzentration (Trägerdichte) ein Kathodenzerstäubungsprozess eingesetzt wird, wobei zur Einstellung der oben genannten Eigenschaften alleine oder in Kombination mit anderen Zerstäubungsprozessparametern der Sauerstofffluss im Plasma genutzt wird.

6. Verwendung der Bauteile gemäß einem der Ansprüche 1 bis 3 oder hergestellt gemäß Anspruch 5 in einer photovoltaischen Solarzelle.

7. Verwendung der Bauteile gemäß einem der Ansprüche 1 bis 4 oder hergestellt gemäß Anspruch 5 in einem elektrischen oder/und optischen Bauteil.
